# EUROPÄISCHE PATENTSCHRIFT

(11) **EP 4 556 773 B1**
(45) Veröffentlichungstag und Bekanntmachung des Hinweises auf die Patenterteilung: **24.06.2026**
(21) Anmeldenummer: 24212885.8
(22) Anmeldetag: 14.11.2024
(51) Int. Cl.: F16L 13/08, F16L 41/08, F28D 1/00, F28F 3/12, H01M 10/613, H01M 10/625, H01M 10/6556, H01M 10/6567, F28D 1/03, F28D 21/00

(54) **TEMPERIERPLATTE UND VERFAHREN ZUR HERSTELLUNG EINER TEMPERIERPLATTE**
TEMPERATURE-CONTROL PLATE AND METHOD FOR PRODUCING A TEMPERATURE-CONTROL PLATE
PLAQUE DE THERMORÉGULATION ET PROCÉDÉ DE FABRICATION D'UNE PLAQUE DE THERMORÉGULATION

(30) Priorität: 16.11.2023 DE 102023131965
(43) Veröffentlichungstag der Anmeldung: 21.05.2025
(73) Patentinhaber: Benteler Automobiltechnik GmbH, 33102 Paderborn (DE)
(72) Erfinder: Grußmann, Elmar, 33184 Altenbeken (DE)
(74) Vertreter: Ksoll, Peter

(56) Entgegenhaltungen:
- DE-A1- 102018 123 972
- DE-A1- 19 805 439
- US-A1- 2018 238 481
- US-A1- 2021 033 349

## Beschreibung

Die Erfindung betrifft eine Temperierplatte zur Temperierung von elektronischen Bauteilen und/oder Batterien sowie ein Verfahren zur Herstellung von Temperierplatten.

Insbesondere betrifft die Erfindung eine Kühlplatte zur Batteriekühlung, insbesondere zur Kühlung einer Batterie von Kraftfahrzeugen.

In Elektro- oder Hybridfahrzeugen kommen Hochvoltbatteriesysteme zum Einsatz. Zur Sicherung von Reichweite, Fahrleistung und Ladeleistung ebenso wie der Lebensdauer von elektrisch angetriebenen Fahrzeugen ist ein Thermomanagement der Batterien erforderlich. Um die Batterien in einem optimalen Temperaturbereich zu halten, kommen Temperiervorrichtungen zum Einsatz, die sicherstellen sollen, dass überschüssige Abwärme, die beim Betreiben der Batterien entstehen, von den Batterien abgeführt und die Batterien auf einem gleichmäßigen Temperaturniveau gehalten werden.

Zur Temperierung von Batterien bzw. Batteriemodulen werden Temperierplatten eingesetzt, welche die Batterien direkt oder indirekt kontaktieren. Die Temperierplatten werden von einem Temperierfluid durchflossen. Solche Temperierplatten bestehen üblicherweise aus zwei Plattenelementen, die zusammengesetzt zu einem Plattenkörper einen oder mehrere dazwischenliegende Kanäle begrenzen. Durch den oder die Kanäle wird das Temperierfluid geführt. Üblicherweise sind die Temperierplatten aus Leichtmetallblechen, insbesondere Aluminiumblechen gefertigt.

Um das Temperierfluid der Temperierplatte zu- und abzuführen, werden die Platten mit Anschlussstutzen versehen. In der Regel werden die Anschlussstutzen formgebend oder spanabhebend gefertigt. Die Befestigung der Anschlussstutzen an einer Temperierplatte wird stoffschlüssig durch Schweißen, Löten oder Kleben vorgenommen. Auch Schraubverbindungen sind bekannt.

Die Festlegung der Anschlussstutzen nach der Herstellung des Plattenkörpers einer Temperierplatte erfordert einen zusätzlichen Fügeschritt und ist entsprechend aufwendig.

Im Stand der Technik sind Temperierplatten in Form von Kühlplatten bekannt.

Eine löttechnisch gefügte Kühlplatte gebildet aus einer Strukturplatte und einer Deckplatte ist in der DE 10 2014 217 728 A1 beschrieben.

Eine Kühlplatte und ein Verfahren zur Herstellung einer Kühlplatte zählt durch die DE 10 2018 123 972 A1 zum Stand der Technik. Die Kühlplatte weist einen Anschlussstutzen für ein Kühlfluid auf, wobei der Anschlussstutzen einen Montageflansch und einen Steckabschnitt besitzt. Der Montageflansch liegt am Plattenkörper der Kühlplatte an. Der Steckabschnitt ist in einer Montageöffnung des Plattenkörpers positioniert sowie plastisch verformt und mit dem Plattenkörper gefügt.

Die DE 198 05 439 A1 offenbart ein Verfahren zur Herstellung eines Stapelwärmeübertragers und einen dadurch hergestellten Wärmeübertrager. Der Wärmeübertrager weist einen Plattenkörper in Form einer Abschlussplatte auf. Speziell wird dort vorgeschlagen, vor dem Aufeinanderstapeln die Abschlussplatte mechanisch mit den Anschlussstutzen zu verbinden. Dazu wird an der Befestigungsstelle eine mechanische Verformung eines Bereichs des Anschlussstutzens und/oder der Aufnahmeöffnung der Anschlussplatte soweit vorgenommen, dass der Anschlussstutzen mechanisch fest und unverdrehbar mit der Abschlussplatte verbunden ist. Der Anschlussstutzen weist dann einen Außenflansch und einen Steckabschnitt auf, wobei der Außenflansch außen an der Anschlussplatte anliegt. Der Steckabschnitt ist in einer Montageöffnung der Anschlussplatte positioniert und ein Endabschnitt des Steckabschnitts umgeformt. Die Montageöffnung ist in einer Ausformung der Anschlussplatte angeordnet, wobei ein umlaufender Rand der Montageöffnung gegenüber der Plattenebene des ersten Plattenelements verlagert ist. Der Endabschnitt ist zu einem Innenflansch geformt, wobei zwischen dem Außenflansch und dem Innenflansch eine Ringnut ausgebildet ist und der Rand in der Ringnut aufgenommen ist.

Eine vergleichbare Anschlusskonfiguration eines Anschlussstutzens an ein Plattenelement eines Plattenkörpers eines Plattenwärmetauschers geht auch aus der US 2021/0033349 A1 hervor.

In der US 2018/0238481 A1 wird ein Verfahren zum Löten eines Anbauteils an ein Rohr und eine entsprechende Baugruppe offenbart.

Weiterhin zählt durch die DE 10 2018 123972 A1 eine Kühlplatte und ein Verfahren zur Herstellung einer Kühlplatte zum Stand der Technik. Die Kühlplatte weist einen Plattenkörper mit einem Anschlussstutzen auf. Der Anschlussstutzen besitzt einen Montageflansch und einen Steckabschnitt. Mit dem Steckabschnitt ist der Anschlussstutzen in eine Montageöffnung des Plattenkörpers positioniert und plastisch verformt, wodurch der Anschlussstutzen und der Plattenkörper miteinander gefügt sind.

Problematisch sind bei stoffschlüssigen Verbindungen von Temperierplatte bzw. Kühlplatte und Anschlussstutzen mögliche Undichtigkeiten, insbesondere infolge von thermischen Verzügen und der damit verbundene Nachbearbeitungsaufwand.

Der Erfindung liegt ausgehend vom Stand der Technik die Aufgabe zugrunde, eine funktional und herstellungstechnisch verbesserte Temperierplatte zu schaffen mit einem rationell und prozesssicher gefügten Anschlussstutzen sowie ein vorteilhaftes Verfahren zur Herstellung einer solchen Temperierplatte aufzuzeigen.

Die Lösung des gegenständlichen Teils der Aufgabe besteht in einer Temperierplatte gemäß den Merkmalen von Anspruch 1.

Der verfahrensmäßige Teil der Aufgabe wird durch ein Verfahren gemäß Anspruch 6 gelöst.

Vorteilhafte Ausgestaltungen und Weiterbildungen der Erfindung sind Gegenstand der abhängigen Ansprüche.

Eine Temperierplatte weist einen aus zwei Plattenelementen gebildeten Plattenkörper auf. Über Anschlussstutzen erfolgt die Zuleitung und Ableitung eines Temperierfluids. Die Anschlussstutzen sind mit dem Plattenkörper bzw. dessen Plattenelementen stoffschlüssig gefügt. Bei den Plattenelementen handelt es sich insbesondere um eine Kanalplatte und eine Bodenplatte, welche zu einem Plattenstapel zusammengeführt und miteinander gefügt den Plattenkörper bilden. Die Plattenelemente bestehen aus Leichtmetall oder einer Leichtmetalllegierung, insbesondere einer Aluminiumlegierung. Zumindest ein Plattenelement des Plattenkörpers der Temperierplatte weist eine Kanalstruktur zur Durchleitung eines Temperierfluids auf. Die Plattenelemente sind mittels Presslöten stoffschlüssig gefügt. Der Lötvorgang wird in einem Formlötwerkzeug durchgeführt. Hierzu wird ein aus den beiden Plattenelementen gebildeter Plattenstapel in dem Formlötwerkzeug eingespannt, aneinander gepresst und auf eine Temperatur oberhalb der Schmelztemperatur des zwischen den Plattenelementen applizierten Lotwerkstoff aufgeheizt, so dass der Lotwerkstoff durch Schmelzen in eine flüssige Phase übergeht und nach dem Erstarren des Lotwerkstoffs eine stoffschlüssige Verbindung der Plattenelemente an den aneinander liegenden Fügeflächen entsteht.

Zur Ausbildung eines oder mehrerer Kanäle in zumindest einem der Plattenelemente werden die Plattenelemente in dem Formlötwerkzeug eingespannt und ein Zwischenraum zwischen den Plattenelementen mit Innendruck beaufschlagt. Hierzu wird ein Wirkmedium in den Zwischenraum geleitet und eine Kanalstruktur mit zumindest einem Kanal oder mehreren Kanälen innenhochdrucktechnisch erzeugt.

Der Anschlussstutzen einer erfindungsgemäßen Temperierplatte weist einen Außenflansch sowie einen Steckabschnitt auf. Der Außenflansch liegt außenseitig an einem Plattenelement des Plattenkörpers der Temperierplatte an. Der Steckabschnitt ist in einer Montageöffnung des Plattenelements positioniert sowie plastisch umgeformt. Die Montageöffnung ist in einer Ausformung im ersten Plattenelement angeordnet. Durch die Ausformung ist ein umlaufender Rand der Montageöffnung gegenüber der Plattenebene des ersten Plattenelements verlagert. Der Anschlussstutzen ist mit seinem Steckabschnitt durch die Montageöffnung im Plattenelement gesteckt. Ein Endabschnitt des Steckabschnitts ist durch plastische Umformung zu einem Innenflansch geformt. Der Innenflansch erstreckt sich radial umlaufend nach außen. Zwischen dem Außenflansch und dem Innenflansch ist eine Ringnut ausgebildet. Der Rand der Montageöffnung verläuft in der Ringnut. Der umlaufende Rand der Montageöffnung ist zwischen dem Außenflansch und dem Innenflansch formschlüssig und fluiddicht gefügt. Durch die Umbördelung des Endabschnitts wird der Innenflansch gebildet und eine Crimpverbindung zwischen dem Anschlussstutzen und dem ersten Plattenelement erzeugt.

Die Montageöffnung und der Durchmesser des Steckabschnitts sind konfigurativ aufeinander abgestimmt. Die Montageöffnung kann insbesondere rund, oval oder langlochartig ausgeführt sein. Die Montageöffnung ist stanztechnisch im ersten Plattenelement hergestellt. Die Montageöffnung kann vor dem Herstellen der Ausformung, während dem Herstellen der Ausformung oder nach dem Herstellen der Ausformung in das erste Plattenelement eingebracht werden.

Der Anschlussstutzen ist durch die Crimpverbindung fest mit dem Plattenelement verbunden. Das Plattenelement kann der Weiterverwendung zugeführt werden und bildet das erste Plattenelement eines Plattenstapels zur Herstellung eines Plattenkörpers einer Temperierplatte.

Die Plattenelemente untereinander sowie zumindest ein Plattenelement und der Anschlussstutzen bzw. die Anschlussstutzen sind stoffschlüssig miteinander gefügt und zwar löttechnisch vorzugsweise presslöttechnisch.

Die Ausformung ist als lokale Vertiefung in einem Plattenelement ausgebildet. Die Ausformung ist napf- oder schalenförmig konfiguriert. Die Vertiefung kann einen runden, ovalen oder langlochförmigen Umfang aufweisen. Die Tiefe der Ausformung ist im Verhältnis zum kleinsten Durchmesser der Ausformung gering. Die Ausformung weist einen Umfang und eine Tiefe auf, die so bemessen sind, dass der Innenflansch in der Ausformung aufgenommen ist.

Für die Praxis vorteilhaft ist die Wandstärke des Innenflanschs zwischen größer oder gleich 0,5 mm und kleiner oder gleich 1,0 mm bemessen ist.

Besonders vorteilhaft besitzt die Ausformung eine Tiefe, die größer oder gleich der Wandstärke des Innenflanschs bemessen ist. Insbesondere ist die Ausformung geometrisch so bemessen, dass der Innenflansch in der Aufnahme aufgenommen ist und im Wesentlichen bündig mit der benachbarten Innenfläche des ersten Plattenelements abschließt. Vorteilhafterweise steht der Innenflansch nicht gegenüber der Innenfläche des ersten Plattenelements vor. Im Wesentlichen bündig bedeutet, dass die Innenseite des Innenflanschs und die Innenfläche des ersten Plattenelements auf gleicher Höhe abschließen unter Berücksichtigung von bauteiltechnischen Toleranzen.

Die Erfindung sieht vor, dass zwischen dem Außenflansch und dem ersten Plattenelement ein Lotwerkstoff, insbesondere ein Ring aus Lotwerkstoff, also ein Lotring eingegliedert ist. Der Lotwerkstoff bzw. der Lotring kann auch eine Dichtung bilden. Der Lotwerkstoff schmilzt bei der presslöttechnischen Fügung der Plattenelemente und des Anschlussstutzens. Nach Erstarren des Lotes wird eine stoffschlüssige Verbindung zwischen dem Außenflansch und dem zwischen Außenflansch und Innenflansch eingespannten umlaufenden Rand der Montageöffnung hergestellt.

Erfindungsgemäß ist der Lotwerkstoff, insbesondere der Lotring, in einer Aufnahme im Außenflansch angeordnet. Hierdurch entsteht eine zweite formschlüssige und fluiddichte Verbindung.

Ein Verfahren zur Herstellung einer Temperierplatte weist folgende Schritte auf:
- Bereitstellen eines Anschlussstutzens, welcher einen Außenflansch und einen Steckabschnitt aufweist;
- Bereitstellen eines ersten Plattenelements;
- Ausbilden einer Ausformung in dem ersten Plattenelement und Herstellen einer Montageöffnung in dem ersten Plattenelement,
- wobei beim Ausbilden der Ausformung ein Boden der Ausformung und/oder ein umlaufender Rand der Montageöffnung gegenüber der Plattenebene des ersten Plattenkörpers verlagert wird;
- Einführen des Steckabschnitts in die Montageöffnung bis der Außenflansch am ersten Plattenelement anliegt, wobei zwischen dem Außenflansch und dem ersten Plattenelement ein Lotwerkstoff, insbesondere ein Lotring, eingeglieder wird;
- Umformen eines Endabschnitts des Steckabschnitts zu einem Innenflansch,
- wobei zwischen dem Außenflansch und dem Innenflansch eine Ringnut gebildet wird und der Rand der Montageöffnung in der Ringnut zwischen dem Außenflansch und dem Innenflansch fixiert wird;
- Bereitstellen eines zweiten Plattenelements und Bilden eines Plattenstapels aus dem ersten Plattenelement und dem zweiten Plattenelement, wobei zwischen den Plattenelementen ein Lotwerkstoff appliziert ist oder wird;
- Einlegen des Plattenstapels in ein beheiztes Formlötwerkzeug, welches ein Unterwerkzeug und ein Oberwerkzeug aufweist;
- Schließen des Formlötwerkzeus und Einklemmen des Plattenstapels zwischen dem Unterwerkzeug und dem Oberwerkzeug;
- Aufheizen des Plattenstapels;
- Beaufschlagung eines Zwischenraums zwischen den Plattenelementen des Plattenstapels mit Innendruck durch Einleiten eines Wirkmediums in den Zwischenraum und Ausbilden eines Kanals in zumindest einem Plattenelement;
- Schmelzen des Lotwerkstoffs zwischen den Plattenelementen und löttechnische Fügung der Plattenelemente an in Anlage befindlichen Fügeflächen und löttechnische Fügung des Anschlussstutzens mit dem ersten Plattenelement;
- Öffnen des Formlötwerkzeugs und Entnahme der Temperierplatte aus dem Form lötwerkzeug.

Die Herstellung der lokalen Ausformung im ersten Plattenelement und die Herstellung einer Montageöffnung können zeitparallel oder zeitlich relativ zueinander versetzt erfolgen. Zunächst kann die Ausformung in Form einer lokalen Vertiefung bzw. Vorprägung in einem Bereich des ersten Plattenelements gebildet und anschließend in der Ausformung bzw. im Boden der Ausformung eine Montageöffnung gestanzt werden. Möglich ist es aber auch, dass die Ausformung und die Montageöffnung zeitparallel hergestellt werden. Auch kann zunächst eine Montageöffnung in dem Plattenelement hergestellt werden und anschließend der Bereich um die Montageöffnung umgeformt und umformtechnisch die Ausformung ausgebildet werden.

Durch die Ausformung wird ein Boden der Ausformung und/oder ein umlaufender Rand der Montageöffnung gegenüber der Plattenebene des ersten Plattenkörpers verlagert. Der Rand der Montageöffnung verläuft dann insbesondere S-förmig eingezogen. In die Montageöffnung wird der Anschlussstutzen mit seinem Steckabschnitt eingeführt bis der Außenflansch am ersten Plattenelement anliegt.

Der Endabschnitt des Steckstutzens wird dann plastisch umgeformt und ein Innenflansch gebildet.

Der Innenflansch am Steckabschnitt wird umlaufend radial nach außen geformt. Hierbei ist der Innenflansch in einem Winkel von im Wesentlichen 90° zur Längsachse des Anschlussstutzens orientiert. In der zwischen dem Außenflansch und dem Innenflansch ausgebildeten Ringnut ist der Rand der Montageöffnung formschlüssig und fluiddicht aufgenommen.

Die Umformung des Endabschnitts am Steckabschnitt erfolgt vorzugsweise zweistufig. In einer ersten Umformstufe wird der Endabschnitt nach außen umgeformt bzw. gebogen. Hierbei wird der Endabschnitt vorzugsweise in einem Winkel von ca. 45° zur Längsachse des Anschlussstutzens gebogen. In einer zweiten Umformstufe wird der Endabschnitt radial umgestellt und zwar insbesondere in einem Winkel von ca. 90° zur Längsachse des Anschlussstutzens.

Zwischen Außenflansch und Innenflansch und dem dazwischen in der Ringnut verlaufenden Rand der Montageöffnung entsteht eine Crimpverbindung durch plastische Verformung der Fügepartner, insbesondere des Innenflansches.

Die Plattenelemente werden in einem Formlötwerkzeug stoffschlüssig miteinander verbunden. Im Formlötwerkzeug erfolgt auch die löttechnische Verbindung des Anschlussstutzens mit dem ersten Plattenelement.

Das Formlötwerkzeug ist auf eine Werkzeugtemperatur aufgeheizt, bei der sowohl der Innenhochdruckumformvorgang zur Ausbildung des Kanals als auch der löttechnische Fügeprozess durchgeführt wird. Insbesondere beträgt die Werkzeugtemperatur zwischen 540° C und 670° C, besonders vorteilhaft liegt die Werkzeugtemperatur zwischen 550° C und 640° C.

Zur Herstellung einer Temperierplatte wird ein Plattenstapel gebildet, der aus einem ersten Plattenelement und einem zweiten Plattenelement besteht. Die Plattenelemente bestehen aus einem metallischen Werkstoff, insbesondere einer Leichtmetalllegierung. Zwischen den Plattenelementen ist ein Lotwerkstoff appliziert oder der Lotwerkstoff wird beim Bilden des Plattenstapels appliziert. Zumindest das erste Plattenelement weist einen mit diesem erfindungsgemäß gefügten Anschlussstutzen auf. Der Plattenstapel wird in das beheizte Formlötwerkzeug eingelegt. Dieses weist ein Unterwerkzeug und ein Oberwerkzeug auf. Das Formwerkzeug wird zugefahren, wobei das Unterwerkzeug und das Oberwerkzeug relativ aufeinander zu verlagert werden.

Eine vorteilhafte Ausbildung des erfindungsgemäßen Verfahrens sieht vor, dass der Schließvorgang des Formlötwerkzeugs vor Erreichen der Schließposition unterbrochen wird. Das Oberwerkzeug und das Unterwerkzeug werden bei eingelegtem Plattenstapel in dieser Halteposition in einem Abstand zueinander gehalten. Die Halteposition wird für eine Haltezeit beibehalten. Hierbei erfolgt eine Aufheizung des auf dem Unterwerkzeug aufliegenden Plattenstapels. Im Anschluss an die Haltezeit wird die Schließbewegung fortgesetzt, das Formlötwerkzeug geschlossen und der Plattenstapel zwischen dem Unterwerkzeug und dem Oberwerkzeug eingespannt. Im Formlötwerkzeug eingespannt, erfolgt eine weitere Aufheizung des Plattenstapels bis auf Löttemperatur. Zur Ausbildung eines oder mehrerer Kanäle in zumindest einem der Plattenelemente wird in einem Zwischenraum zwischen den im Formlötwerkzeug eingespannten Plattenelementen mit Innendruck beaufschlagt. Hierzu wird ein Wirkmedium in den Zwischenraum geleitet und eine Kanalstruktur mit zumindest einem oder mehreren Kanälen innenhochdrucktechnisch erzeugt. Die Einleitung des Wirkmediums in einen Zwischenraum zwischen den Plattenelementen kann über den vorher formschlüssig und fluiddicht gefügten Anschlussstutzen erfolgen.

Nach Öffnen des Formlötwerkzeugs und gegebenenfalls einer Kühlphase kann die Temperierplatte aus dem Lötwerkzeug entnommen werden.

Die Erfindung ist nachfolgend anhand von Zeichnungen näher beschrieben. Es zeigen:
- Figur 1: einen Ausschnitt aus einer Temperierplatte mit der Darstellung eines Anschlussstutzens in der Perspektive;
- Figur 2: einen Ausschnitt aus einem Plattenelement mit der Draufsicht auf eine Montageöffnung;
- Figur 3: einen Schnitt durch die Darstellung der Figur 2 entlang der Linie A-A nach der Herstellung einer Ausformung;
- Figur 4: einen Anschlussstutzen in einer Querschnittsdarstellung;
- Figur 5: einen Schnitt durch ein erstes Plattenelement einer Temperierplatte und einen damit verbundenen Anschlussstutzen;
- Figur 6: ein Umformwerkzeug mit der Darstellung einer ersten Umformstufe zur Festlegung eines Anschlussstutzens in einer Montageöffnung eines ersten Plattenelements und
- Figur 7: ein Umformwerkzeug mit der Darstellung einer zweiten Umformstufe zur Festlegung eines Anschlussstutzens in einer Montageöffnung eines ersten Plattenelements.

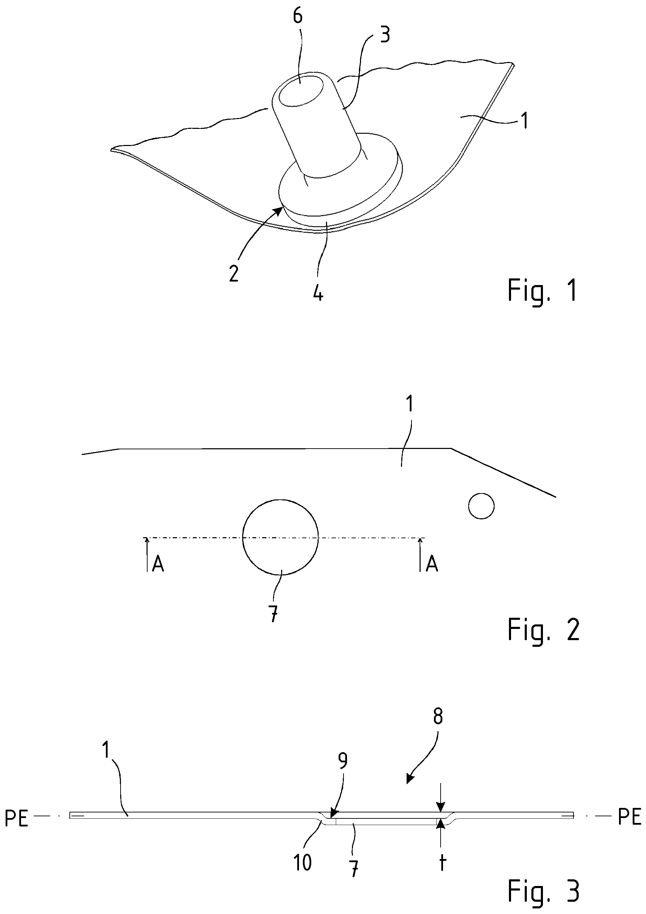

Die Figur 1 zeigt einen Ausschnitt aus einem ersten Plattenelement 1 einer Temperierplatte und einen an dem Plattenelement 1 festgelegten Anschlussstutzen 2.

Eine Temperierplatte dient zur Batteriekühlung, insbesondere einer Fahrzeugbatterie eines Kraftfahrzeugs. Üblicherweise weist eine Temperierplatte einen Plattenkörper auf, der aus zwei Plattenelementen gebildet ist. Von den Plattenelementen ist hier das erste Plattenelement 1 gezeigt. Üblicherweise besitzt eine Temperierplatte zwei Anschlussstutzen 2 für den Zulauf und den Ablauf von Temperierfluid. Bei dem hier dargestellten ersten Plattenelement 1 handelt es sich um eine vollständig oder nahezu vollständig ebene Bodenplatte. Komplettiert wird der Plattenkörper der Temperierplatte durch ein zweites Plattenelement, bei dem es sich um eine Kanalplatte handelt, die eine Kanalstruktur mit zumindest einem Temperierkanal aufweist.

Das erste Plattenelement 1 und das zweite Plattenelement werden flächig aufeinander positioniert und bilden den Plattenkörper. Die aneinander liegenden Flächen der Plattenelemente sind ganz oder bereichsweise mit einem Lotwerkstoff versehen. Insbesondere ist ein Lotwerkstoff in Form einer plattierten Lotschicht auf einem der Plattenelemente vorappliziert. Die aneinander liegenden Flächen der Plattenelemente sind ganz oder bereichsweise miteinander gefügt. Der Anschlussstutzen 2 ist mit dem ersten Plattenelement 1 formschlüssig und stoffschlüssig gefügt.

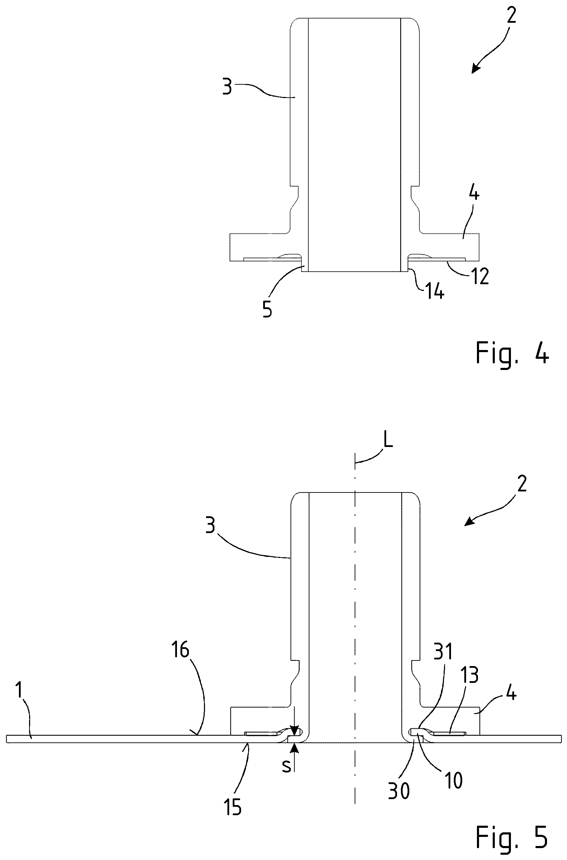

Der Anschlussstutzen 2 weist einen äußeren Anschlussabschnitt 3 auf. Dieser ist zum Anschluss einer Temperierfluidleitung konfiguriert. Des Weiteren weist der Anschlussstutzen einen sich radial vom Anschlussabschnitt 3 nach außen erstreckenden Außenflansch 4 auf (siehe hierzu Figur 4). In Verlängerung des Anschlussabschnitts 3 besitzt der Anschlussstutzen 2 einen Steckabschnitt 5. Durch den Anschlussstutzen 2 erstreckt sich in dessen Längsrichtung eine Durchgangsöffnung 6.

Im ersten Plattenelement 1 ist eine Montageöffnung 7 eingebracht (siehe hierzu Figuren 2 und 3). Im dargestellten Ausführungsbeispiel ist die Montageöffnung 7 rund. Die Montageöffnung 7 weist einen Durchmesser auf, der auf den Außendurchmesser des Steckabschnitts 5 abgestimmt.

Die Montageöffnung 7 ist in einer Ausformung 8 des ersten Plattenelements 1 angeordnet. Die Ausformung 8 ist durch eine lokale Vertiefung 9 im ersten Plattenelement 1 gebildet. Die Montageöffnung 7 weist einen umlaufenden Rand 10 auf. Der Rand 10 ist S-förmig gekrümmt konfiguriert. Der Rand 10 der Montageöffnung 7 ist gegenüber der Plattenebene PE des ersten Plattenelements 1 in eine Richtung verlagert. Dies erfolgt umformtechnisch durch eine Schub- oder Druckumformung.

Der Außenflansch 4 weist an seiner zum Plattenelement 1 gewandten Flanschseite 11 eine Aufnahme 12 in Form einer umlaufenden Nut auf. In der Aufnahme ist ein Lotwerkstoff in Form eines Lotrings 13 aufgenommen.

Der Anschlussstutzen 2 ist am ersten Plattenelement 1 fixiert. Dies erfolgt formschlüssig durch eine plastische Verformung eines Endabschnitts 14 des Steckabschnitts 5. Der Endabschnitt 14 wird dazu umgebördelt und eine Crimpverbindung hergestellt.

Einen formschlüssig mit dem ersten Plattenelement 1 verbundenen Anschlussstutzen 2 zeigt die Darstellung der Figur 5.

Zur Montage des Anschlussstutzens 2 an dem ersten Plattenelement 1 wird der Anschlussstutzen 2 mit seinem Steckabschnitt 5 in die Montageöffnung 7 eingeführt bis der Außenflansch 4 außen an dem ersten Plattenelement 1 anliegt. Der Steckabschnitt 5 steht dann in Längsrichtung des Anschlussstutzens 2 gegenüber einer Innenfläche 15 des ersten Plattenelements 1 vor. Die Flanschseite 11 und der in der Aufnahme 12 positionierte Lotring 13 liegen an einer Außenfläche 16 des ersten Plattenelements 1 benachbart zur Ausformung 8 umlaufend an.

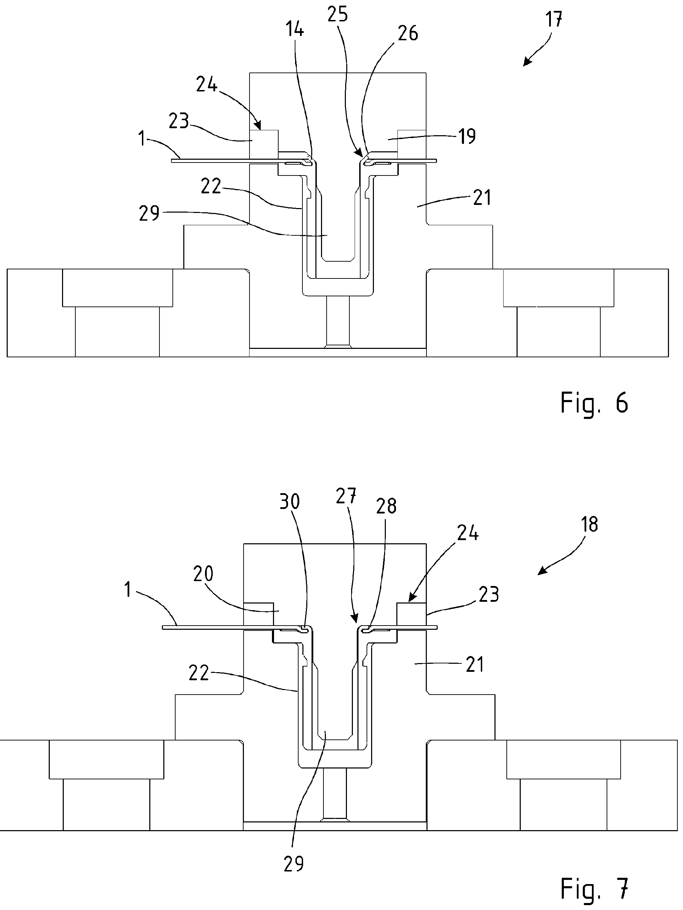

Die formschlüssige Crimpfügung des Anschlussstutzens 2 mit dem ersten Plattenelement 1 erfolgt zweistufig. Der Fügeprozess ist anhand der Figuren 6 und 7 erläutert.

Die erste Umformstufe ist in Figur 6 gezeigt.

Die zweite Umformstufe zeigt die Darstellung der Figur 7.

Der Bördelvorgang und die Herstellung der Crimpverbindung zwischen dem Anschlussstutzen und dem ersten Plattenelement 1 erfolgt in zwei Formwerkzeugen 17, 18, die gleichartig aufgebaut sind und sich im Wesentlichen nur durch die formgebende Kontur ihrer Patrize 19 bzw. 20 unterscheiden.

In der Figur 6 ist das erste Formwerkzeug 17 dargestellt.

Die Figur 7 zeigt das zweite Formwerkzeug 18.

Ein Formwerkzeug 17, 18 weist im Wesentlichen eine oberen Patrize 19 bzw.20, einen Gegenhalter 21 mit einer Stutzenaufnahme 22 sowie einen Niederhalter 23 und ein im Niederhalter 23 angeordnetes oberes Dämpferelement 24 auf.

Zur Herstellung der Clinchverbindung zwischen dem Anschlussstutzen 2 und dem ersten Plattenelement 1 wird das Plattenelement 1 mit dem in die Montageöffnung 7 eingesteckten Steckabschnitt 5 des Anschlussstutzens 2 im ersten Formwerkzeug 17 positioniert. Der Anschlussstutzen 2 ragt mit seinem Anschlussabschnitt 3 in die Stutzenaufnahme 22. Der Steckabschnitt 5 steht axial in Längsrichtung des Anschlussstutzens 2 in Richtung der Patrize 19 vor. Das erste Plattenelement 1 wird zwischen dem Gegenhalter 21 und dem Niederhalter 23 eingeklemmt und die Patrize 19 axial verlagert. Die Patrize 19 wird in Richtung auf den Endabschnitt 14 abgesenkt. Dies erfolgt durch Aufbringen einer äußeren Axialkraft. Die Patrize 19 weist eine Formkontur 25 auf, welche bei der axialen Verlagerung der Patrize 19 innenseitig am Endabschnitt 14 des Steckabschnitts 5 zur Anlage kommt. Die Formkontur weist eine in einem Winkel ca. 45° verlaufende Schrägfläche 26 auf. Diese kommt am Endabschnitt 14 zur Anlage. Die Schrägfläche 26 wirkt als Keil und überträgt eine Radialkraft auf den Endabschnitt 14, so dass dieser relativ zur Längsachse L des Anschlussstutzens 2 nach außen gebogen wird. Dies zeigt die Darstellung der Figur 6. Der Endabschnitt 14 ist in einem Winkel von ca. 45° zur Längsachse L des Anschlussstutzens 2 nach außen gebogen.

Die Bauteile, also das erste Plattenelement 1 und der an dem ersten Plattenelement 1 vorfixierte Anschlussstutzen 2, werden dann in das zweite Formwerkzeug 18 überführt. Die Patrize 20 des zweiten Formwerkzeugs 18 weist eine Formkontur 27 auf, die dazu eingerichtet und bestimmt ist, den in der ersten Umformstufe nach außen gebogenen Endabschnitt 14 des Steckabschnitts 5 rechtwinklig umzulegen bzw. zu bördeln. Hierzu weist die Formkontur 27 eine rechtwinklig zur Längsachse L des Anschlussstutzens 2 orientierte Formfläche 28 auf. Durch Absenken der Patrize 20 wird der Endabschnitt 14 rechtwinklig, insbesondere in einem Winkel von ca. 90° zur Längsachse L des Anschlussstutzens 2 umgeformt und die Bauteile miteinander vercrimpt. Dies zeigt die Darstellung der Figur 7.

Sowohl das Formwerkzeug 17 als auch das Formwerkzeug 18 weisen einen Dorn 29 auf, der in Verlängerung der Patrize 19 bzw. 20 vorsteht und in die Durchgangsöffnung 6 des Anschlussstutzens 2 ragt. Hierdurch wird der Anschlussstutzen 2 innenseitig insbesondere am inneren Umfang der Durchgangsöffnung 6 im Bereich des Außenflanschs 4 und des Steckabschnitts 5 abgestützt. Der Dorn 29 kann im Zusammenwirken mit einem inneren Anschlag als Höhen- bzw. Wegbegrenzung fungieren. Hierzu wird der axiale Verlagerungsweg der Patrizen 19, 20 durch einen Anschlag begrenzt, der stirnseitig am Dorn 29 zur Anlage gelangt.

Der Endabschnitt 14 des Steckabschnitts 5 wird zu einem radial vom Anschlussstutzen 2 nach außen gerichteten Innenflansch 30 geformt (siehe hierzu auch die Figur 5).

Zwischen dem Außenflansch 4 und dem Innenflansch 30 des Anschlussstutzens 2 ist eine Ringnut 31 gebildet. Der umlaufende Rand 10 der Montageöffnung 7 ist in der Ringnut 31 aufgenommen und zwischen dem Außenflansch 4 und dem Innenflansch 30 formschlüssig vercrimpt und fluiddicht gefügt.

Der Innenflansch 30 weist eine Wandstärke s auf. Die Ausformung 8 besitzt eine Tiefe t. Die Tiefe t der Ausformung 8 ist größer oder gleich der Wandstärke s des Innenflanschs 30 bemessen. Die Ausformung 8 ist geometrisch so konfiguriert, dass der Innenflansch 30 in der Ausformung 8 bzw. der Vertiefung 9 aufgenommen ist und insbesondere im Wesentlichen bündig mit der benachbarten Innenfläche 15 des ersten Plattenelements 1 abschließt.

Die Wandstärke s beträgt zwischen 0,5 mm und 1,0 mm jeweils einschließlich. Entsprechend ist die Tiefe t der Ausformung 8 bemessen. Insbesondere entsprechen die Tiefe t der Ausformung 8 und die Wandstärke s des Innenflanschs 30 einander und sind im Wesentlichen gleich bemessen, so dass in dem Übergangsbereich laminare Strömungsverhältnisse beim Durchfluss eines Temperierfluids vorliegen.

Das erste Plattenelement 1 mit dem daran gefügten Anschlussstutzen 2 wird dann dem weiteren Herstellungsprozess zur Herstellung einer Temperierplatte zugeführt. Das erste Plattenelement 1 wird mit einem zweiten Plattenelement zu einem Plattenstapel zusammengeführt. Zumindest eines der beiden Plattenelemente ist mit einem Lotwerkstoff, insbesondere mit einer plattierten Lotwerkstoffschicht versehen. Der Plattenstapel aus den beiden Plattenelementen wird in einem Formlötwerkzeug eingespannt. Hierzu wird das Formlötwerkzeug geschlossen und der Plattenstapel zwischen dem Unterwerkzeug und dem Oberwerkzeug des Formlötwerkzeugs eingeklemmt. Im Formlötwerkzeug wird der Plattenstapel auf eine Temperatur oberhalb der Schmelztemperatur des Lotwerkstoffs aufgeheizt. Im Formlötwerkzeug 15, 16 eingespannt wird ein Wirkmedium in einem Zwischenraum zwischen den Plattenelementen eingeleitet und eine Kanalstruktur mit zumindest einen Kanal innenhochdrucktechnisch erzeugt. Das Wirkmedium kann über den Anschlussstutzen 2 zugeführt werden. Im Formlötwerkzeug wird auch der in der Aufnahme 12 positionierte Lotring 13 aufgeschmolzen, so dass dieser in eine flüssige Phase übergeht. Nach dem Erstarren des Lotwerkstoffs entsteht eine stoffschlüssige Verbindung der Plattenelemente untereinander sowie des ersten Plattenelements 1 und des Anschlussstutzens 2 an den aneinander liegenden Fügeflächen.

### Bezugszeichen:

- 1 -: Plattenelement
- 2 -: Anschlussstutzen
- 3 -: Anschlussabschnitt
- 4 -: Außenflansch
- 5 -: Steckabschnitt
- 6 -: Durchgangsöffnung
- 7 -: Montageöffnung
- 8 -: Ausformung
- 9 -: Vertiefung
- 10 -: Rand von 7
- 11 -: Flanschseite
- 12 -: Aufnahme
- 13 -: Lotring
- 14 -: Endabschnitt
- 15 -: Innenfläche von 1
- 16 -: Außenfläche von 1
- 17 -: Formwerkzeug
- 18 -: Formwerkzeug
- 19 -: Patrize
- 20 -: Patrize
- 21 -: Gegenhalter
- 22 -: Stutzenaufnahme
- 23 -: Niederhalter
- 24 -: Dämpferelement
- 25 -: Formkontur
- 26 -: Schrägfläche
- 27 -: Formkontur
- 28 -: Formfläche
- 29 -: Dorn
- 30 -: Innenflansch
- 31 -: Ringnut
- L -: Längsachse
- PE -: Plattenebene
- s -: Wandstärke
- t -: Tiefe

## Patentansprüche

1. Temperierplatte zur Temperierung von elektronischen Bauteilen und/oder Batterien mit einem Plattenkörper, welcher ein erstes Plattenelement (1) und ein zweites Plattenelement sowie zumindest einen Anschlussstutzen (2) für ein Temperierfluid aufweist, die löttechnisch miteinander gefügt sind, wobei der Anschlussstutzen (2) einen Außenflansch (4) und einen Steckabschnitt (5) aufweist, wobei der Außenflansch (4) außen an dem ersten Plattenelement (1) anliegt und der Steckabschnitt (5) in einer Montageöffnung (7) des ersten Plattenelements (1) positioniert ist und ein Endabschnitt (14) des Steckabschnitts (5) umgeformt ist sowie die Montageöffnung (7) in einer Ausformung (8) im ersten Plattenelement (1) angeordnet ist, wobei ein umlaufender Rand (10) der Montageöffnung (7) gegenüber der Plattenebene (PE) des ersten Plattenelements (1) verlagert ist und der Endabschnitt (14) zu einem Innenflansch (30) geformt ist, wobei zwischen dem Außenflansch (4) und dem Innenflansch (30) eine Ringnut (31) ausgebildet ist und der Rand (10) in der Ringnut (31) aufgenommen ist, **dadurch gekennzeichnet, dass** zwischen dem Außenflansch (4) und dem ersten Plattenelement (1) ein Lotwerkstoff eingegliedert ist, wobei der Lotwerkstoff in einer Aufnahme (12) im Außenflansch (4) angeordnet ist.

2. Temperierplatte nach Anspruch 1, **dadurch gekennzeichnet, dass** der Innenflansch (30) eine Wandstärke (s) besitzt und die Ausformung (8) eine Tiefe (t) besitzt, wobei die Tiefe (t) der Ausformung (8) größer oder gleich (≥) der Wandstärke (s) des Innenflanschs (30) bemessen ist.

3. Temperierplatte nach Anspruch 1 oder 2, **dadurch gekennzeichnet, dass** die Ausformung (8) geometrisch so bemessen ist, dass der Innenflansch (30) darin aufgenommen ist und insbesondere im Wesentlichen bündig mit einer benachbarten Innenfläche (15) des ersten Plattenelements (1) abschließt.

4. Temperierplatte nach einem der Ansprüche 1 bis 3, **dadurch gekennzeichnet, dass** der Lotwerkstoff ein Lotring (13) ist.

5. Temperierplatte nach einem der Ansprüche 1 bis 4, **dadurch gekennzeichnet, dass** die Plattenelemente (1) und/oder der Anschlussstutzen (2) aus einem Leichtmetallwerkstoff, insbesondere aus einer Aluminiumlegierung bestehen.

6. Verfahren zur Herstellung einer Temperierplatte nach einem der Ansprüche 1 bis 5, **gekennzeichnet durch** folgende Schritte:
- Bereitstellen eines Anschlussstutzens (2), welcher einen Außenflansch (4) und einen Steckabschnitt (5) aufweist;
- Bereitstellen eines ersten Plattenelements (1);
- Ausbilden einer Ausformung (8) in dem ersten Plattenelement (1) und Herstellen einer Montageöffnung (7) in dem ersten Plattenelement (1),
- wobei beim Ausbilden der Ausformung (8) ein Boden der Ausformung (8) und/oder ein umlaufender Rand (10) der Montageöffnung (7) gegenüber der Plattenebene (PE) des ersten Plattenkörpers (1) verlagert wird;
- Einführen des Steckabschnitts (5) in die Montageöffnung (7) bis der Außenflansch (4) am ersten Plattenelement (1) anliegt, wobei zwischen dem Außenflansch (4) und dem ersten Plattenelement (1) ein Lotwerkstoff, insbesondere ein Lotring (13) eingegliedert wird;
- Umformen eines Endabschnitts (14) des Steckabschnitts (5) zu einem Innenflansch (30),
- wobei zwischen dem Außenflansch (4) und dem Innenflansch (30) eine Ringnut (31) gebildet wird und der Rand (10) der Montageöffnung (7) in der Ringnut (31) zwischen dem Außenflansch (4) und dem Innenflansch (30) fixiert wird;
- Bereitstellen eines zweiten Plattenelements und Bilden eines Plattenstapels aus dem ersten Plattenelement (1) und dem zweiten Plattenelement, wobei zwischen den Plattenelementen ein Lotwerkstoff appliziert ist oder wird;
- Einlegen des Plattenstapels in ein beheiztes Formlötwerkzeug, welches ein Unterwerkzeug und ein Oberwerkzeug aufweist;
- Schließen des Formlötwerkzeus und Einklemmen des Plattenstapels zwischen dem Unterwerkzeug und dem Oberwerkzeug;
- Aufheizen des Plattenstapels;
- Beaufschlagung eines Zwischenraums zwischen den Plattenelementen des Plattenstapels mit Innendruck durch Einleiten eines Wirkmediums in den Zwischenraum und Ausbilden eines Kanals in zumindest einem Plattenelement;
- Schmelzen des Lotwerkstoffs zwischen den Plattenelementen und löttechnische Fügung der Plattenelemente an in Anlage befindlichen Fügeflächen und löttechnische Fügung des Anschlussstutzens (2) mit dem ersten Plattenelement (1);
- Öffnen des Formlötwerkzeugs und Entnahme der Temperierplatte aus dem Form lötwerkzeug.

7. Verfahren nach Anspruch 6, **dadurch gekennzeichnet, dass** der Innenflansch (30) am Steckabschnitt (5) umlaufend radial nach außen geformt wird.

8. Verfahren nach Anspruch 6 oder 7, **dadurch gekennzeichnet, dass** die Ausformung (8) im ersten Plattenelement (1) geometrisch so bemessen ausgebildet wird, dass der Innenflansch (30) in der Aufnahme (12) liegt und insbesondere im Wesentlichen bündig mit einer benachbarten Innenfläche (15) des ersten Plattenelements (1) abschließt.

9. Verfahren nach einem der Ansprüche 6 bis 8, **dadurch gekennzeichnet, dass** die Umformung des Endabschnitts (14) am Steckabschnitt (5) zweistufig durchgeführt wird, wobei in einer ersten Umformstufe der Endabschnitt (14) nach außen gebogen wird, insbesondere in einem Winkel von ca. 45° zur Längsachse (L) des Anschlussstutzens (2) gebogen wird und in einer zweiten Umformstufe der Endabschnitt (14) radial umgestellt wird, insbesondere in einem Winkel von ca. 90° zur Längsachse (L) des Anschlussstutzens (2).

10. Verfahren nach einem der Ansprüche 6 bis 9, **dadurch gekennzeichnet, dass** der Rand (10) der Montageöffnung (7) in der Ringnut (31) zwischen dem Außenflansch (4) und dem Innenflansch (30) formschlüssig und fluiddicht gefügt wird.

11. Verfahren nach einem der Ansprüche 6 bis 10, **dadurch gekennzeichnet, dass** das Formlötwerkzeug auf eine Werkzeugtemperatur zwischen 540 °C und 670 °C, insbesondere zwischen 550 °C und 640 °C, aufgeheizt wird.

12. Verfahren nach einem der Ansprüche 6 bis 11, **dadurch gekennzeichnet, dass** der Schließvorgang des Formlötwergzeugs vor Erreichen des Schließposition für eine Haltezeit unterbrochen wird, wobei das Oberwerkzeug und das Unterwerkzeug bei eingelegte Plattenstapel in einem Abstand zueinander gehalten werden und nach der Haltezeit das Formlötwerkzeug geschlossen und der Plattenstapel zwischen dem Unterwerkzeug und dem Oberwerkzeug eingeklemmt wird.

## Claims

1. A temperature control plate for temperature control of electronic components and/or batteries, comprising a plate body which has a first plate element (1) and a second plate element as well as at least one connection socket (2) for a temperature control fluid, which are joined together by soldering, wherein the connection socket (2) comprises an outer flange (4) and a plug section (5), wherein the outer flange (4) rests externally against the first plate element (1) and the plug section (5) is positioned in a mounting opening (7) of the first plate element (1), and an end section (14) of the plug section (5) is deformed, and the mounting opening (7) is arranged in a formed portion (8) in the first plate element (1), wherein a circumferential edge (10) of the mounting opening (7) is offset relative to the plate plane (PE) of the first plate element (1), and the end section (14) is formed into an inner flange (30), wherein an annular groove (31) is formed between the outer flange (4) and the inner flange (30), and the edge (10) is received in the annular groove (31), **characterized in that** a solder material is incorporated between the outer flange (4) and the first plate element (1), wherein the solder material is arranged in a receptacle (12) in the outer flange (4).

2. The temperature control plate according to claim 1, **characterized in that** the inner flange (30) has a wall thickness (s) and the formed portion (8) has a depth (t), wherein the depth (t) of the formed portion (8) is dimensioned to be greater than or equal to (≥) the wall thickness (s) of the inner flange (30).

3. The temperature control plate according to claim 1 or 2, **characterized in that** the formed portion (8) is geometrically dimensioned such that the inner flange (30) is received therein and in particular terminates substantially flush with an adjacent inner surface (15) of the first plate element (1).

4. The temperature control plate according to any one of claims 1 to 3, **characterized in that** the solder material is a solder ring (13).

5. The temperature control plate according to any one of claims 1 to 4, **characterized in that** the plate elements (1) and/or the connection socket (2) consist of a light metal material, in particular of an aluminum alloy.

6. A method for producing a temperature control plate according to any one of claims 1 to 5, **characterized by** the following steps:
• providing a connection socket (2) comprising an outer flange (4) and a plug section (5);
• providing a first plate element (1);
• forming a formed portion (8) in the first plate element (1) and producing a mounting opening (7) in the first plate element (1),
• wherein, during formation of the formed portion (8), a bottom of the formed portion (8) and/or a circumferential edge (10) of the mounting opening (7) is displaced relative to the plate plane (PE) of the first plate body (1);
• inserting the plug section (5) into the mounting opening (7) until the outer flange (4) rests against the first plate element (1), wherein a solder material, in particular a solder ring (13), is incorporated between the outer flange (4) and the first plate element (1);
• deforming an end section (14) of the plug section (5) into an inner flange (30),
• wherein an annular groove (31) is formed between the outer flange (4) and the inner flange (30), and the edge (10) of the mounting opening (7) is fixed in the annular groove (31) between the outer flange (4) and the inner flange (30);
• providing a second plate element and forming a plate stack from the first plate element (1) and the second plate element, wherein a solder material is or will be applied between the plate elements;
• placing the plate stack into a heated forming-soldering tool comprising a lower tool and an upper tool;
• closing the forming-soldering tool and clamping the plate stack between the lower tool and the upper tool;
• heating the plate stack;
• applying internal pressure to an intermediate space between the plate elements of the plate stack by introducing an active medium into the intermediate space and forming a channel in at least one plate element;
• melting the solder material between the plate elements and solder-joining the plate elements at joining surfaces in contact, and solder-joining the connection socket (2) to the first plate element (1);
• opening the forming-soldering tool and removing the temperature control plate from the forming-soldering tool.

7. The method according to claim 6, **characterized in that** the inner flange (30) is formed circumferentially radially outward on the plug section (5).

8. The method according to claim 6 or 7, **characterized in that** the formed portion (8) in the first plate element (1) is geometrically dimensioned such that the inner flange (30) is located in the receptacle (12) and in particular terminates substantially flush with an adjacent inner surface (15) of the first plate element (1).

9. The method according to any one of claims 6 to 8, **characterized in that** the deformation of the end section (14) on the plug section (5) is carried out in two stages, wherein, in a first deformation stage, the end section (14) is bent outward, in particular at an angle of approximately 45° relative to the longitudinal axis (L) of the connection socket (2), and wherein, in a second deformation stage, the end section (14) is bent radially over, in particular at an angle of approximately 90° relative to the longitudinal axis (L) of the connection socket (2).

10. The method according to any one of claims 6 to 9, **characterized in that** the edge (10) of the mounting opening (7) is joined in the annular groove (31) between the outer flange (4) and the inner flange (30) in a form-fitting and fluid-tight manner.

11. The method according to any one of claims 6 to 10, **characterized in that** the forming-soldering tool is heated to a tool temperature between 540°C and 670°C, in particular between 550°C and 640°C.

12. The method according to any one of claims 6 to 11, **characterized in that** the closing process of the forming-soldering tool is interrupted before reaching the closed position for a holding period, wherein the upper tool and the lower tool are held at a distance from one another with the plate stack inserted, and wherein, after the holding period, the forming-soldering tool is closed and the plate stack is clamped between the lower tool and the upper tool.

## Revendications

1. Plaque de régulation thermique destinée à la régulation thermique de composants électroniques et/ou de batteries, comprenant un corps de plaque comportant un premier élément de plaque (1) et un second élément de plaque ainsi qu'au moins un raccord tubulaire (2) destiné à un fluide de régulation thermique, lesquels sont assemblés entre eux par brasage, le raccord tubulaire (2) comprenant une bride extérieure (4) et une section d'emboîtement (5), la bride extérieure (4) étant appliquée extérieurement contre le premier élément de plaque (1) et la section d'emboîtement (5) étant positionnée dans une ouverture de montage (7) du premier élément de plaque (1), une section d'extrémité (14) de la section d'emboîtement (5) étant déformée, et l'ouverture de montage (7) étant disposée dans un emboutissage (8) du premier élément de plaque (1), un bord périphérique (10) de l'ouverture de montage (7) étant décalé par rapport au plan de plaque (PE) du premier élément de plaque (1), et la section d'extrémité (14) étant formée en une bride intérieure (30), une gorge annulaire (31) étant formée entre la bride extérieure (4) et la bride intérieure (30), et le bord (10) étant reçu dans la gorge annulaire (31), **caractérisée en ce qu'**un matériau de brasage est interposé entre la bride extérieure (4) et le premier élément de plaque (1), le matériau de brasage étant disposé dans un logement (12) de la bride extérieure (4).

2. Plaque de régulation thermique selon la revendication 1, **caractérisée en ce que** la bride intérieure (30) présente une épaisseur de paroi (s) et l'emboutissage (8) présente une profondeur (t), la profondeur (t) de l'emboutissage (8) étant dimensionnée de manière à être supérieure ou égale (≥) à l'épaisseur de paroi (s) de la bride intérieure (30).

3. Plaque de régulation thermique selon la revendication 1 ou 2, **caractérisée en ce que** l'emboutissage (8) est dimensionné géométriquement de telle sorte que la bride intérieure (30) y soit reçue et, en particulier, affleure sensiblement une surface intérieure adjacente (15) du premier élément de plaque (1).

4. Plaque de régulation thermique selon l'une quelconque des revendications 1 à 3, **caractérisée en ce que** le matériau de brasage est un anneau de brasage (13).

5. Plaque de régulation thermique selon l'une quelconque des revendications 1 à 4, **caractérisée en ce que** les éléments de plaque (1) et/ou le raccord tubulaire (2) sont constitués d'un matériau métallique léger, en particulier d'un alliage d'aluminium.

6. Procédé de fabrication d'une plaque de régulation thermique selon l'une quelconque des revendications 1 à 5, **caractérisé par** les étapes suivantes :
• fourniture d'un raccord tubulaire (2) comprenant une bride extérieure (4) et une section d'emboîtement (5);
• fourniture d'un premier élément de plaque (1);
• formation d'un emboutissage (8) dans le premier élément de plaque (1) et réalisation d'une ouverture de montage (7) dans le premier élément de plaque (1),
• lors de la formation de l'emboutissage (8), un fond de l'emboutissage (8) et/ou un bord périphérique (10) de l'ouverture de montage (7) étant déplacé par rapport au plan de plaque (PE) du premier corps de plaque (1);
• insertion de la section d'emboîtement (5) dans l'ouverture de montage (7) jusqu'à ce que la bride extérieure (4) soit appliquée contre le premier élément de plaque (1), un matériau de brasage, en particulier un anneau de brasage (13), étant interposé entre la bride extérieure (4) et le premier élément de plaque (1);
• déformation d'une section d'extrémité (14) de la section d'emboîtement (5) en une bride intérieure (30),
• une gorge annulaire (31) étant formée entre la bride extérieure (4) et la bride intérieure (30), et le bord (10) de l'ouverture de montage (7) étant fixé dans la gorge annulaire (31) entre la bride extérieure (4) et la bride intérieure (30) ;
• fourniture d'un second élément de plaque et formation d'un empilement de plaques à partir du premier élément de plaque (1) et du second élément de plaque, un matériau de brasage étant ou devant être appliqué entre les éléments de plaque;
• introduction de l'empilement de plaques dans un outil de formage-brasage chauffé comprenant un outil inférieur et un outil supérieur ;
• fermeture de l'outil de formage-brasage et serrage de l'empilement de plaques entre l'outil inférieur et l'outil supérieur ;
• chauffage de l'empilement de plaques ;
• application d'une pression interne à un espace intermédiaire entre les éléments de plaque de l'empilement de plaques par introduction d'un fluide actif dans l'espace intermédiaire et formation d'un canal dans au moins un élément de plaque;
• fusion du matériau de brasage entre les éléments de plaque et assemblage par brasage des éléments de plaque au niveau des surfaces d'assemblage en contact, ainsi qu'assemblage par brasage du raccord tubulaire (2) avec le premier élément de plaque (1);
• ouverture de l'outil de formage-brasage et retrait de la plaque de régulation thermique de l'outil de formage-brasage.

7. Procédé selon la revendication 6, **caractérisé en ce que** la bride intérieure (30) est formée radialement vers l'extérieur sur tout le pourtour de la section d'emboîtement (5).

8. Procédé selon la revendication 6 ou 7, **caractérisé en ce que** l'emboutissage (8) dans le premier élément de plaque (1) est dimensionné géométriquement de telle sorte que la bride intérieure (30) soit logée dans le logement (12) et, en particulier, affleure sensiblement une surface intérieure adjacente (15) du premier élément de plaque (1).

9. Procédé selon l'une quelconque des revendications 6 à 8, **caractérisé en ce que** la déformation de la section d'extrémité (14) de la section d'emboîtement (5) est réalisée en deux étapes, la section d'extrémité (14) étant, dans une première étape de déformation, pliée vers l'extérieur, notamment selon un angle d'environ 45° par rapport à l'axe longitudinal (L) du raccord tubulaire (2), et, dans une seconde étape de déformation, rabattue radialement, notamment selon un angle d'environ 90° par rapport à l'axe longitudinal (L) du raccord tubulaire (2).

10. Procédé selon l'une quelconque des revendications 6 à 9, **caractérisé en ce que** le bord (10) de l'ouverture de montage (7) est assemblé dans la gorge annulaire (31) entre la bride extérieure (4) et la bride intérieure (30) de manière à assurer un verrouillage par forme et une étanchéité aux fluides.

11. Procédé selon l'une quelconque des revendications 6 à 10, **caractérisé en ce que** l'outil de formage-brasage est chauffé à une température d'outil comprise entre 540°C et 670°C, en particulier entre 550°C et 640°C.

12. Procédé selon l'une quelconque des revendications 6 à 11, **caractérisé en ce que** le processus de fermeture de l'outil de formage-brasage est interrompu avant l'atteinte de la position de fermeture pendant une durée de maintien, l'outil supérieur et l'outil inférieur étant maintenus espacés l'un de l'autre avec l'empilement de plaques inséré, et **en ce qu'**après la durée de maintien, l'outil de formage-brasage est fermé et l'empilement de plaques est serré entre l'outil inférieur et l'outil supérieur.
